# EUROPEAN PATENT APPLICATION

(11) **EP 4 525 045 A1**
(43) Date of publication of application: **19.03.2025**
(21) Application number: 23197586.3
(22) Date of filing: 15.09.2023
(51) Int. Cl.: H01L 27/15, H01L 33/00

(54) **SEMICONDUCTOR STRUCTURES FOR MICROLEDS**

(71) Applicant: Hexagem AB, 223 63 Lund (SE)
(72) Inventor: SAMUELSON, Lars, 223 63 Lund (SE); BI, Zhaoxia, 223 63 Lund (SE); BJÖRK, Mikael, 223 63 Lund (SE); HEURLIN, Magnus, 223 63 Lund (SE); BERG, Martin, 223 63 Lund (SE)
(74) Representative: Neij & Lindberg AB

(57) **Abstract**

The proposed solution relates to a semiconductor structure (80) for micro light-emitting diodes, microLEDs, comprising an epiwafer (10) and a plurality of InGaN platelets (100) monolithically grown on the epiwafer. Each InGaN platelet comprises a QW layer. The plurality of InGaN platelets comprises individual InGaN platelets configured for red, green, and blue light emission, respectively. The solution further relates to a microLED device (800) comprising the semiconductor structure, and a method for fabricating the semiconductor structure.

## Description

### Technical Field

The technology relates to the field of semiconductor structures, specifically for microLEDs (micro light-emitting diodes) used in display and lighting applications. This field focuses on improving the efficiency, performance, and manufacturing processes of microLEDs, which are known for their high brightness, low power consumption, long lifetimes, and very fast response time and high modulation speeds.

### Background

MicroLEDs have emerged as a promising technology for high-resolution displays in various applications, such as augmented reality (AR), virtual reality (VR), mixed reality (MR), smartwatches, and head-up displays (HUDs). These applications require small pixel sizes, typically below 10 µm, to achieve high resolution and compact form factors. The use of microLEDs offers several advantages over competing technologies, such as liquid crystal displays (LCDs) and organic light-emitting diodes (OLEDs), including higher brightness, longer lifetime, and lower power consumption.

However, there are several challenges associated with the fabrication and performance of microLEDs at small pixel sizes. One significant issue is the drastic loss of external quantum efficiency as pixel size decreases. This efficiency loss is mainly due to increased influence of side-wall damages caused by dry etching.. As a result, the development of efficient microLEDs with sub-10 µm pixel sizes remains a challenge. The other issue is the microLEDs emitting red light, where both nitride microLEDs and AlInGaP ones are not satisfying in terms of efficiency brightness.

Another challenge in the fabrication of microLEDs is the assembly of red, green, and blue (RGB) pixels for high-resolution displays. Currently, the three colours are fabricated on separate wafers using epitaxial methods and need to be picked out of those wafers and placed on the backplane/driving circuits of the display to build up the array of RGB pixels. Various techniques exist to accomplish this, many of which are not yet technologically mature. To date, no pick and place methods can successfully be used in production to assemble displays having pixel sizes below 10 µm.

For small displays, like AR/VR/MR, smartwatches, etc., a possibility is to bond the LED wafers directly to Si CMOS active drive circuitry. This still requires the assembly of all three colours into RGB pixels. For pixel sizes above 10 µm, this can be achieved through several approaches, including pick and place methods, mechanical stacking of all three colour sources on top of each other, or multi-junction epilayers connected via e.g., tunnel junctions during epitaxy. However, these approaches are not suitable for pixel sizes below 10 µm.

Several approaches have been proposed to address these challenges, such as direct growth of red, green, and blue LEDs on the same epiwafer, i.e., a semiconductor wafer having a common growth layer, so that pick and place mass transfer can be avoided and instead a single step wafer bonding could be used to attach the LEDs to the CMOS chips. However, a technology is still missing to accomplish an RGB epiwafer with pixel sizes below 10 µm and as small as sub-1-µm with external quantum efficiencies in the double-digit range for all three colours.

### Summary

The proposed solution relates to devices and methods as outlined in the independent claims. Further aspects and features are outlined below, and at least partly set out in the dependent claims.

According to a first aspect of the disclosure, a semiconductor structure for microLEDs is provided. The structure comprises an epiwafer and a plurality of InGaN platelets grown through mask openings of the epiwafer. The InGaN platelets include a quantum well layer, which quantum well layer may comprise a plurality of quantum wells. Optionally, each InGaN platelet has a top c-plane surface connectable to a driver circuit for generating light emission. The quantum well layer may be formed in the InGaN platelets and can be sandwiched between two InGaN layers, such as a lower n-InGaN part and an upper p-InGaN part. The quantum well layer can be configured at a height in the InGaN platelets correlating with an emission wavelength.

The proposed solution is based on the inventors' research which indicates that when the quantum well layer is formed closer to the top portion of the pyramid, where the diameter is also smaller, the quantum well grows thicker, possibly also with higher concentration of indium, meaning that its emission shifts to longer wavelengths. The proposed solution thus involves fabrication of a microLED arranged for emission of a certain wavelength, configured by careful selective epitaxial growth of the quantum well layer at a certain height. Specifically, this is used for monolithic growth of RGB triplets from a common epiwafer, where InGaN platelets with the quantum well layer at different height at least partly dictates the emission color.

The InGaN platelets may be arranged in groups on the epiwafer for red, green, and blue light emission. The InGaN platelets can be arranged in a trigonal pattern, and the InGaN platelets configured for emission of the same colour can be arranged in a hexagonal pattern. The InGaN platelets can be arranged in groups configured for different emission wavelengths, and the emission wavelength of the InGaN platelets may increase with the spacing within the group. The InGaN platelets configured for emission of red light can have a base layer, adjacent to the epiwafer, of InGaN with a first Indium concentration, and a buffer layer between the base layer and the quantum well layer, of InGaN with a second Indium concentration which is higher than the first Indium concentration.

According to a second aspect of the disclosure, a method of fabricating a semiconductor structure for microLEDs is provided. The method includes epitaxial growth of InGaN pyramids through mask openings of an epiwafer, truncating the InGaN pyramids, e.g., by etching or annealing, to form truncated InGaN pyramids, and growing individual quantum well layers over the truncated pyramids to form individual InGaN platelets. The originally grown InGaN pyramids may be grown concurrently with a common composition, and thus the same indium concentration. The truncated pyramids, which comprise the remainder of the originally grown pyramids after truncation, form respective base layers for forming the respective and individual monolithically grown InGaN platelets. Optionally, the method may comprise growing a buffer layer, on each base layer, before growing the quantum well layer. Indium concentration of the respective buffer layer may be tailored to the colour of emission of the respective InGaN platelet. Selective masking of the InGaN platelets may be employed for epitaxial growth of quantum well layers, and the optional buffer layers, for emission in a wavelength region of one of red, green, and blue. Growth of the quantum well layers can be performed at a height over the epiwafer correlating with an intended emission wavelength. The formation of quantum well layers on the InGaN platelets for different emission wavelengths can be performed in a common epitaxy process.

The proposed solution thus offers a semiconductor structure with a plurality of InGaN platelets monolithically grown from a common epiwafer, wherein the InGaN platelets are usable for forming RGB pixels. The proposed solution further offers a microLED device comprising the semiconductor structure connected to a driver circuit.

The proposed solution offers a huge advantage over prior art solutions. In state-of-the-art LED growth, one color LED, either blue, green or red, can be made on one wafer (or one growth run). To fabricate full color microLED displays, mass transfer needs to be used to transfer sub-pixels of R, G, B microLEDs. This is a very challenging step, specifically not practical for the microLED below 10 um. In contrast, the proposed solution provides RGB sub-pixels on the same wafer by consecutive growths. This way, each full RGB pixel, containing three R/G/B sub-pixels, can be directly bonded to the driving circuit, avoiding the usage of mass transfer. This provides monolithic integration of RGB platelet microLEDs by epitaxy, such as Metal-Organic Chemical Vapor Deposition (MOCVD).

### Brief Description of the Drawings

Fig. 1 schematically illustrates three epitaxially grown semiconductor structures, in the form of hexagonal InGaN pyramids, based on which various embodiments of the proposed solution may be obtained.
Fig. 2 schematically illustrates an example of an InGaN platelet having a single quantum well according to one embodiment.
Fig. 3 schematically illustrates an example of having a single quantum well sandwiched in between two InGaN layers having lower indium-contents and close to the top c-plane, according to one embodiment.
Fig. 4 schematically illustrates a first example of a process flow for making red, green, and blue InGaN platelets on the same epiwafer, i.e., from the same growth layer, according to the proposed solution.
Fig. 5 schematically illustrates a second example of a process flow for making red, green, and blue InGaN platelet LEDs on the same epiwafer.
Fig. 6 schematically illustrates InGaN platelet composition for RGB growth according to an example of the proposed solution.
Fig. 7 Illustrates an example of the proposed solution, comprising a growth mask hole centre-centre spacing design on the epiwafer for local tuning of growth rate and resulting emission light colour.
Fig. 8A shows a top view of an arrangement of contact on the semiconductor structure for attachment to a driver circuit according to one example.
Fig. 8B schematically illustrates a side view showing the contacts to the semiconductor structure according to one example.
Fig. 8C schematically illustrates a semiconductor device, in which the semiconductor structure is connected to a driver circuit for generating emission of RGB light, according to one example.
Fig. 9 schematically illustrates hexagonal InGaN RGB platelet array design according to one embodiment.
Fig. 10A illustrates a first example of an RGB pixel based on the pattern of Fig. 9.
Fig. 10B illustrates a second example of an RGB pixel based on the pattern of Fig. 9.
Fig. 11 shows an exemplary pixel array layout for a display based on the example of Fig. 10A.

### Detailed Description

The detailed description set forth below provides information and examples of the disclosed technology with sufficient detail to enable those skilled in the art to practice the disclosure.

Ternary InGaN alloys are widely used as active layers (or quantum wells) in nitride LEDs and laser diodes. The thickness of the InGaN active layers is usually no more than 3 nm, mainly in order to limit impacts of quantum confined Stark effect (QCSE) which reduces the spatial overlap between the electron and hole wave functions in the quantum wells. Another reason is that the crystal quality of InGaN can deteriorate quickly when the layer is grown thick, partly due to a large miscibility gap between GaN and InN but mainly due to strain effects from the growth on mismatched substrates. However, the prospect of thick and relaxed InGaN films is highly desirable, for the use as a substrate for nitride optoelectronic devices where high indium-content InGaN active layers are needed.

Selective area growth has been widely used to fabricate GaN in order to reduce density of dislocations arising from the lattice mismatch between the substrate and epitaxial GaN layers. Dislocation-free GaN structures, including nanowires and pyramids, can be grown if the mask holes are made sufficiently small, such as 200 nm or less.

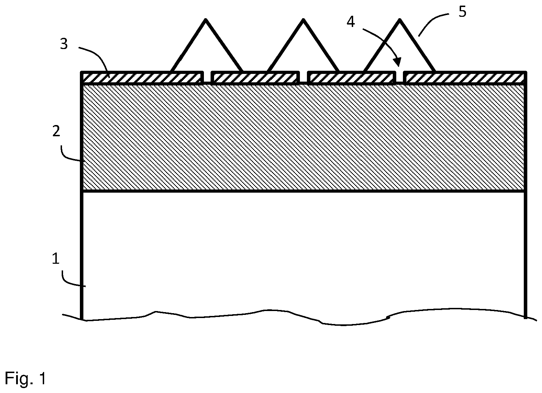

Fig. 1 shows three epitaxially grown semiconductor structures in the form of hexagonal InGaN pyramids, which can be used as a basis for various embodiments of the proposed solution. This drawing illustrates a semiconductor structure which may be fabricated and used as a starting structure for fabricating the InGaN platelets according to the proposed solution. A base substrate 1 of e.g., sapphire or Si, is provided with one or more layers of c-oriented GaN as growth layer 2, such as a (0001)-oriented GaN film. A mask layer 3 of e.g., SiNₓ is formed on top of the GaN layer. Holes (or openings/apertures) 4 are provided in the mask layer. The holes 4 may be manufactured by means of various types of lithography, such as EBL (electron beam lithography), nanoimprint, DUV (Deep UltraViolet) lithography, etc. The holes 4 may be very narrow, e.g., with a diameter of 20-200 nm, 50-150 nm, or 60-100 nm. Growth of a seed of a first III-nitride material, such as GaN, may optionally be performed. In a subsequent step, hexagonal pyramids 5 of InGaN are epitaxially grown over the holes, from the growth layer (optionally from the seeds). The growth takes place with gallium and indium species primarily diffusing from the SiN mask surface to the holes, without any nucleation on the mask surface. This way, growth of InGaN pyramids with an indium composition up to 20% has been realized, as determined by photoluminescence (PL) measurements. The growth of the InGaN pyramids may be carried out with selective doping, such that negatively doped n-InGaN pyramids 5 are obtained. Various examples and aspects related to the prefabrication of the structure of Fig. 1 are disclosed in WO2020187986A1, which is incorporated herein by reference.

The hexagonal InGaN pyramids with a diagonal base size of several hundred nanometers, such as >400 nm, may be used. These pyramids have {101 1̅} side facets, and occasionally a small flat (0001) top facet. Each of the pyramids is a homogeneous InGaN semiconductor structure. In some examples, one or more of the pyramids may be epitaxially grown in two or more epitaxy stages with different, e.g., increasing, indium concentration, as will be described.

The pre-fabrication step of epitaxial growth from the mask holes results in the InGaN pyramids being free, or substantially free, from dislocations. As a result, emission non-uniformity caused by dislocations between pixels (individual semiconductor devices) is avoided. This contributes positively to obtain high quantum efficiency, such as more than 10%. In addition, a very thin GaN buffer/growth layer 2 may be used, e.g., below 1 µm, which results in very low wafer bow. This provides the benefit of high yield processing.

Various aspects of the proposed solutions are based on creating quantum wells (QWs) embedded within InGaN pyramids or truncated InGaN pyramids to obtain InGaN platelets configured to operate as microLEDs, each configured to emit light of one of red, green and blue. Each such InGaN platelet, i.e., for each colour, is in some embodiments processed from an array of InGaN pyramids which are substantially identical, by being concurrently grown from respective mask holes in an epitaxy process.

According to some aspects, the InGaN pyramids are arranged/grown in a first trigonal pattern on the carrier, wherein each InGaN platelet has six neighbour InGaN platelets at the same distance. This way, uniformity in growth of the InGaN pyramids, based on which the InGaN platelets are formed, is obtained. In such embodiments, an RGB triplet may e.g., be defined in a straight line, or in a triangular arrangement.

Use of epitaxially grown InGaN pyramids, grown from small holes to a common growth layer, provides advantages of high crystal quality and high production efficiency of the InGaN platelets.

According to some examples, the pyramid shape of the starting structure is advantageously used, based on the understanding that truncation to create a top c-plane of different truncated pyramid height, i.e., at different elevation over the carrier, or epiwafer, will also provide basis for preparing QWs for emission at different wavelengths (different colours), correlating with the surface size of the c-plane. This example provides for the possibility to grow QW layers (each QW layer comprising one or more QW and associated layers) for all three colours in a common growth process step.

According to some examples, the pre-disposition of separate InGaN pyramids for each pixel according to a growth mask provides an efficient basis for separately masking or not masking selected pyramids, so as to either remove material or epitaxially grow selected InGaN platelet for the purpose of creating InGaN platelet for emission of light in a desired wavelength, such as red, green, or blue.

According to some examples, the pyramids may be configured with a tailored pattern, defined by the arrangement of the mask holes on the epiwafer. In some examples, the pattern may define groups of pixels of the same colour (i.e., configured to emit light of the same colour) having a pre-configured pixel pitch within the group, wherein the pixel pitch is different dependent on colour. Specifically, the pixel pitch PP (e.g., centre to centre distance of the mask holes) within each group is preconfigured to promote different growth of QW layers for different colour groups. This way, QW layers of two or three groups may be grown concurrently in the same epitaxy process.

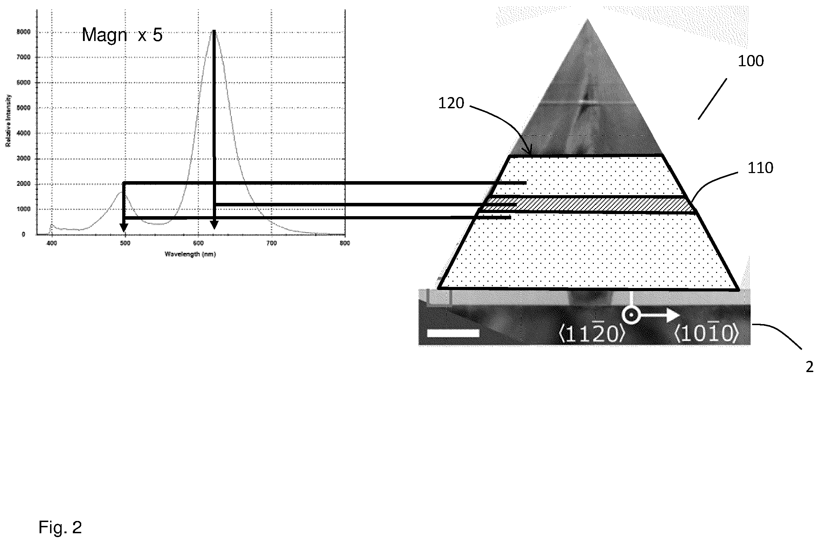

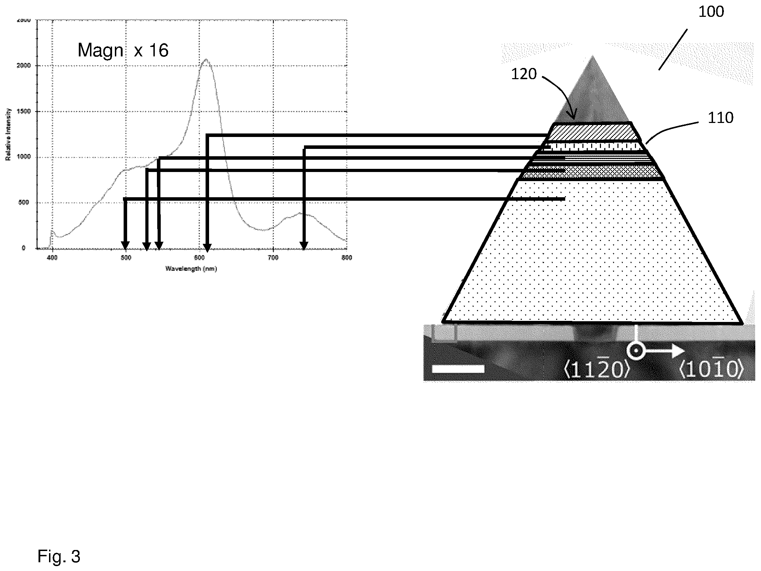

Figs 2 and 3 show different types of InGaN platelets, i.e., InGaN pyramids which have been truncated and subjected to subsequent epitaxial growth to form QW layers and upper p-InGaN growth, according to various examples of the proposed solution.

Fig. 2 illustrates an example of an InGaN platelet 100 comprising a QW layer 110 having a single QW according to one embodiment. The InGaN platelet 100 has a truncated pyramid shape with a substantially planar top surface 120. The InGaN platelet 100 is fabricated from a pyramid grown through mask openings to the growth layer 2, of which a portion is indicated. The QW layer 110 is formed in the InGaN platelet 100 and is configured at a height correlating with an intended emission wavelength. The figure shows an example of an InGaN platelet having a single QW sandwiched in between two InGaN layers having lower indium-contents. Light emission from QW is around 620 nm.

Fig. 3 shows an example of an InGaN platelet 100 having a QW layer 110 comprising a single QW sandwiched in between two InGaN layers with lower indium contents and close to the top c-plane. Light emission from QW has shifted to 750nm due to thicker QW and higher indium contents as compared to Fig. 2, indicating that emission wavelength can be shifted depending on distance to the tip/apex of the pyramid for fixed growth conditions.

The proposed solution includes a method for fabrication of a semiconductor device comprising InGaN platelets configured for red, green, and blue (RGB) emission on the same carrier, which is a common semiconductor substrate, herein also referred to as epiwafer. Each InGaN platelet is thus configured to operate as a microLED, upon connection to a driver circuit.

By employing bottom-up growth, rather than using state of the art plasma etching to remove InGaN material to form InGaN mesas of a certain pixel size, the risk for damaging remaining material for the pixels is minimized, which provides high efficiency.

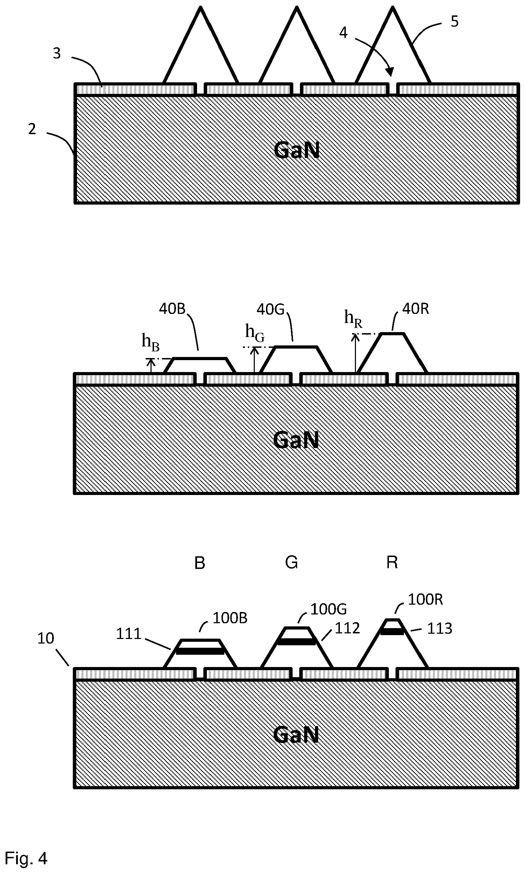

Fig. 4 presents various stages of a first example of a process flow for making red, green, and blue InGaN platelets 100 on the same epiwafer 10 according to the proposed solution. The process includes, or succeeds, epitaxial growth of InGaN pyramids 5 through mask openings 4 of the epiwafer 10. In this context, it may be noted that the epiwafer 10 (or carrier) comprises at least the mask layer 3, whereas the underlying growth layer 2, used for growing the InGaN pyramids through the mask holes, may be removed or thinned after finalizing the InGaN platelets.

The process involves truncation of the InGaN pyramids to form truncated InGaN pyramids, and growing QW layers to form truncated InGaN platelets 100 (100B, 100G, 100R). In the context of the proposed solution, truncation may be obtained using one or more of various types of processes for material removal or redisposition to obtain a truncated pyramid shape. Etching is one example, whereas chemical mechanical polishing (CMP) is another example.

The top image depicts InGaN pyramids of certain indium contents, such as 8-12%, e.g., 10%. This may correspond to Fig. 1. The middle image shows the result after stepwise truncation to define groups of three truncated pyramids 40B, 40G, 40R with exposed top c-planes at three different truncation heights, i.e., with exposed c-planes at different elevation over the carrier, such as over a top surface of the mask layer 3. Truncation involves material removal, e.g., by back-etching, annealing or polishing.

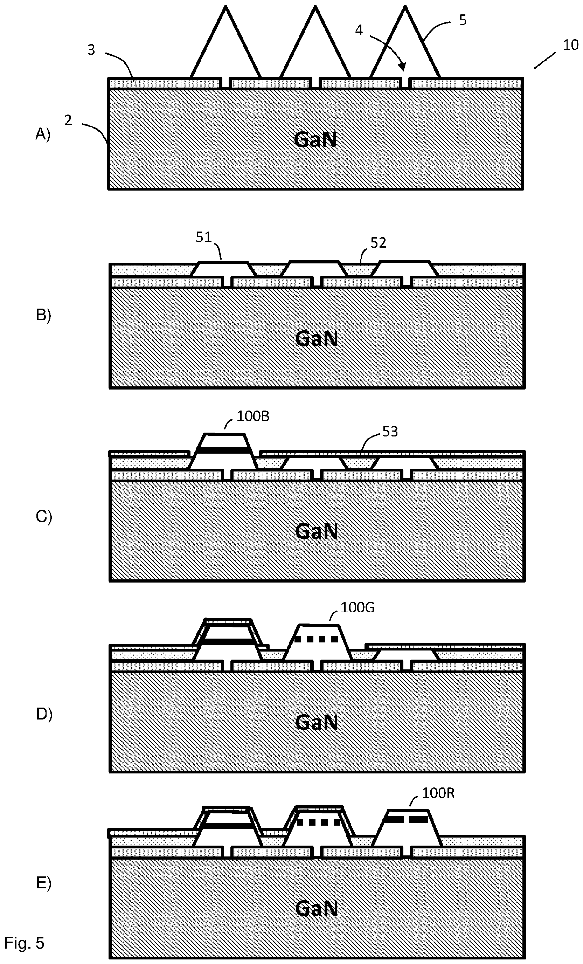

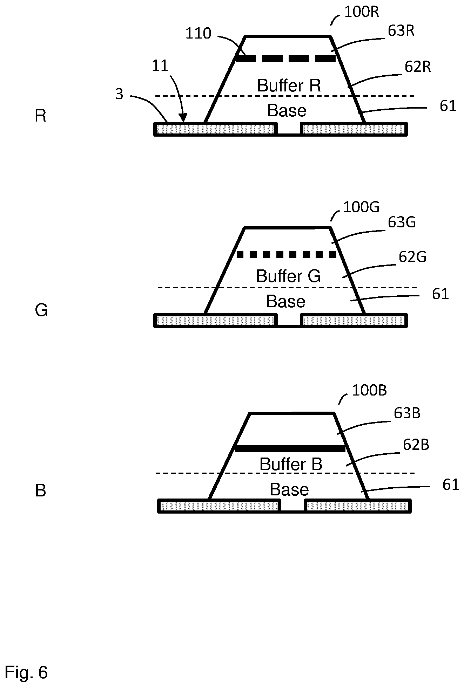

In some examples (as will be described with reference to Figs 5 and 6), this involves truncation of all pyramids to leave respective base layers of a common height, such as 80-120 nm, or about 100 nm, over the carrier top surface. Additional growth of a buffer layer may then subsequently be carried out over the respective base layer. This provides improvement of the upper c-plane surface before QW growth. The indium concentration of the buffer layer may be tailored dependent on the intended emission colour.

The middle image thus shows a group of three truncated pyramids 40B, 40G, 40R with exposed top c-planes at three different truncation heights, i.e., with exposed c-planes at different elevation over the carrier, such as over a top surface of the mask layer 3. Herein, all platelets are thus processed to expose c-planes at three different heights; truncated pyramids 40B with height h_{B} configured for formation of a QW layer for blue emission, truncated pyramids 40G with height h_{G} configured for formation of a QW layer for green emission, and truncated pyramids 40R with height h_{R} configured for formation of a QW layer for red emission.

Quantum well layers 111, 112, 113 may thereafter be grown in a single step epi on the truncated InGaN pyramids 40B, 40G, 40R having different height/top c-plane size, aiming to have RGB microLEDs fabricated in a common epitaxy process. In other words, the same recipe may be used for preparing the layers included in the QW, including an additional InGaN upper layer over the QW, for all colours RGB, which saves processing time.

To achieve the structure of the middle image of Fig. 4, based on the structure of the upper image, a protective layer of resist, or other dielectric material, may first be deposited on the sample surface (top surface of the epiwafer 10 and pyramids 5). In some examples, the resist/dielectric protective layer is chosen to have a similar dry-etching rate as the InGaN material, such as crystalline Al₂O₃. After deposition of the protective layer, the surface may be slightly wave-shaped, following the shape profile of the pyramids. CMP can be used to planarize the protective layer.

According to some examples, where no buffer layer is included, one more layer of other type resist/hard mask can be deposited on the as-prepared surface for lithography, patterning the resist/hard mask so that one group of apertures is made on the top of 1/3 of InGaN pyramids. Then dry etching can be conducted to truncate the InGaN pyramids exposed under said apertures to form top c-planes for one color microLEDs (such as blue). Selective masking is as such a known procedure and is therefore not described or shown in detail.

In one example, the process may continue by removing the top resist/hard mask, and then depositing the resist/dielectric layer again to cover the already-truncated pyramids. By twice repeating procedures above from CMP, two more groups of truncated pyramids with different heights can be prepared for the other two colour microLEDs (green and red). After removing all resist material, the structure of the middle image of Fig. 4 is obtained.

In another example, the first step of etching the top from 1/3 of InGaN pyramids may be succeeded with a step of removing the resist to form apertures over the second group of pyramids, wherein etching may proceed on both the first and second groups of pyramids. Finally, also the remaining pyramids may be uncovered, where after all three are etched. Selected time for these three process steps may be configured to obtain selected truncation height of the respective pyramid to three different heights, according to the middle image of Fig. 4.

In an example where all pyramids are first etched back to form respective base layers, the selective masking process may instead be used for growing the buffer layers.

To end template preparation, the resist/hard mask and the protective layer are removed, and the sample is cleaned for subsequent epitaxy.

The as-fabricated sample, corresponding to the middle image of Fig. 4, may be loaded back to a MOCVD chamber for epitaxy of QW layers 111, 112, 113, which each may comprise an n-type InGaN buffer, InGaN QW, a GaN or AlGaN electron blocking layer and a p-InGaN layer. The smaller the top c-plane is upon QW layer growth, the higher indium content can be obtained in the InGaN QW. By tuning the top c-plane sizes of these three groups of truncated pyramids 40B, 40G, 40R (i.e., by configuring the height of the truncated pyramids) and growth conditions, InGaN QWs emitting blue, green and red light can be obtained in one epitaxy growth process. It shall be noted in this context that each pyramid may be subjected to epitaxy to grow more than one QW per pyramid.

The bottom image of Fig. 4 illustrates the result after single shot epitaxy run on all of the truncated InGaN pyramids 40B, 40G, 40R, resulting in InGaN platelets 100B, 100G, 100R with respective QWs 111, 112, 113 located at three different heights and configured for emission of three distinct colours, i.e., blue, green, and red. It shall be noted that single shot epitaxy refers to the same series of epitaxial growth steps being carried out on all truncated pyramids 40B, 40G, 40R.

As shown in the bottom image, the process of QW layer growth also comprises additional growth of an upper InGaN layer, such as doped p-InGaN. In some examples, growth of the upper InGaN layer is continued to a full pyramid shape of each respective platelet. Thereafter, all platelets are subjected to truncation, e.g., by annealing, etching or polishing, to obtain the same height of all InGaN platelets. This provides a simplified final process, and also results in uniform InGaN height, which simplifies contacting to a driver circuit.

Fig 5 shows another example of a process flow for making red, green, and blue InGaN platelet LEDs on the same epiwafer 10. This process flow includes selective masking of the InGaN platelets for epitaxial growth of QW layers for emission in a wavelength region of one of red, green, and blue.

This process is based on creating QWs of different colours on equally truncated c-plane height (i.e, the base layer), covering selected platelets, and performing epitaxial growth on remaining exposed platelets in three consecutive steps forming R, G, and B LEDs.
A) depicts pyramids of certain Indium contents, such as 8-12%, of n-InGaN. This may correspond to Fig. 1.
B) indicates planarization/truncation of InGaN pyramids to same height (leaving the base layer). In this drawing, each truncated pyramid 51 is surrounded by an additional spacer layer 52 of the same height. The spacer layer 52 is a dielectric material or at least an inorganic material (not resist polymer) as it needs to withstand high temperatures without degrading and contaminating the InGaN. In various embodiments, the spacer layer 52 comprises SiNₓ, Al₂O₃, TiN or other suitable materials.
C) indicates addition of growth mask 53 material onto selected 2/3 of all truncated pyramids followed by epitaxial growth of LED structure comprising a QW layer 111 intended for one colour, e.g., blue light emission, optionally preceded by growth of a buffer layer tailored for blue emission, such as with an indium concentration of 5-10%, which further provides the benefit of reducing any possible band-tail absorption of QW light. The growth mask material may e.g., comprise atomic layer deposited (ALD) Al₂O₃ or SiNₓ.

In other words, after the InGaN pyramids are truncated with either dry-etching or CMP to form the structure of B), the sample surface is covered by a layer of the growth mask material. One group of truncated pyramids is uncovered by lithography and dry etching for subsequent epitaxy of a QW layer (optionally preceded by buffer layer growth) and an upper p-InGaN layer, to form microLEDs 100B configured to emit one colour, such as blue.
D) indicates covering previously grown LED structure 100B in the growth mask material (i.e., by covering the entire sample again with a mask layer, such as ALD Al₂O₃ or SiNₓ), and uncovering half of the remaining truncated pyramids with lithography and dry etching followed by epitaxial growth of LED structures comprising a QW layer to form microLEDs 100G configured to emit a second colour, e.g., green light emission.
E) shows covering previously grown LED structures in growth mask, and uncovering remaining truncated pyramids followed by epitaxial growth of LED structures 100R having QW intended for the final colour, e.g., red light emission.

In this example, separate recipes for epitaxy to create, inter alia, QWs and buffer layers, may be individually employed for each colour of pixel. This provides greater freedom of operation for configuration of InGaN platelets for microLEDs of different colour. This example thus truncates all InGaN pyramids in the same way, then three epi-growths, aiming to get blue, green and red microLEDs, are conducted on selected groups of truncated pyramids while others are covered with mask materials.

Fig. 6 illustrates InGaN platelet composition for RGB growth according to an example of the proposed solution. The InGaN platelets have a base layer 61, adjacent to the surface 11 of the epiwafer, such as the top surface of the mask layer 3. As noted, the base layer 61 may be the remainder of the original pyramid 5, after truncation. The base layer size, which substantially equals the size of the original pyramid base, may be in the range of 700-900 nm, such as about 800 nm point to point of its hexagonal shape. The base layer is made of InGaN (n-InGaN) with a first Indium concentration, such as about 10% or 8-12%, and may be about 100 nm high, or 80-120 nm. A buffer layer 62 is formed between the base layer 61 and the QW layer 110, wherein said buffer layer 62 is made of InGaN with a second Indium concentration which may be different from the first Indium concentration.

For InGaN platelets 100R configured for emission of red light, said buffer layer 62R may be made of InGaN with a second Indium concentration which is higher than the first Indium concentration, such as 18-20%. The buffer layer may be grown to obtain a c-plane surface at a height of about 520-550 nm from the surface of the epiwafer.

According to various embodiments, in order to minimize lattice stress and defect creations, the n-type bottom platelet segment, i.e., the base 61 of the pyramid closest to the mask layer, is designed to have an In-composition corresponding to bandgap luminescence of 420-430nm. For red emitting LEDs 100R the buffer layer 62R of 475nm luminescence is grown before the QW layer 110, whereas the 425nm luminescence layer may be used for green and blue. This way, defect creation may be supressed.

In some examples, either no buffer layer is grown, or a buffer layer with the same indium concentration as the base layer 61 is grown, in the formation of green 100G and blue 100B MicroLEDs.

In other examples, though, buffer layers 62G, 62B of InGaN (n-InGaN) are grown also on the base layer 61 for formation of InGaN platelets for green 100G and blue 100B emission.

For the green InGaN platelet 100G, the buffer layer 62G is formed between the base layer 61 and the QW layer 110, wherein said buffer layer 62G is made of InGaN with a second Indium concentration which is the same or higher than the first Indium concentration, such as 10-15%. The buffer layer may be grown to obtain a c-plane surface at a height of about 360-400 nm from the surface of the epiwafer.

For the blue InGaN platelet 100B, the buffer layer 62B is formed between the base layer 61 and the QW layer 110, wherein said buffer layer 62B is made of InGaN with a second Indium concentration which is the same or lower than the first Indium concentration, such as 5-10%. The buffer layer may be grown to obtain a c-plane surface at a height of about 240-280 nm from the surface of the epiwafer.

For each InGaN platelet 100R, 100G, 100B, further growth of an upper InGaN layer (p-InGaN) 63R, 63G, 63B is carried out over the QW layer 110. Where the initial base layer 61 size is in the range of 700-900 nm, such as about 800 nm point to point, as mentioned, the overall total height of each InGaN platelet may be in the range of 720-770 nm. The base of the respective InGaN platelet may, after the growth steps, have increased to 900-960 nm, according to measurements.

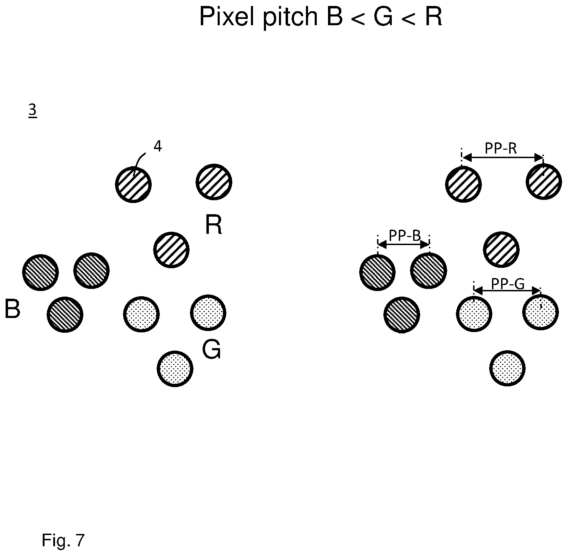

Fig. 7 shows an example of the proposed solution, comprising a center-center spacing design for the holes 4 in the growth mask 3 of the epiwafer 10 for local tuning of growth rate. The drawing schematically illustrates a top view of the mask layer 3. The holes 4 in the mask layer 3 configured for growing the InGaN platelets are arranged in groups for red, green, and blue light emission, respectively. This embodiment is based on the understanding that the emission wavelength of the InGaN platelets increases with the spacing within the group.

According to this embodiment of the proposed solution, local hole spacing variation is thus employed for manufacturing R, G, and B LEDs. By this configuration, a single step epitaxy process may optionally be employed for QW layer formation and top layer growth.

In this context, the proposed lattice design is based on the notion that for selective area growth of InGaN, the indium incorporation depends on the spacing between the holes 3. In the drawing, this spacing is referred to as Pixel Pitch PP. Up to 2 µm or larger spacing, the growth is controlled by adatom diffusion on the mask surface. All the adatoms landing on the mask surface will diffuse to the nearest InGaN pyramid and contribute to the growth there. This way, the growth with larger spacing means a local higher growth rate, leading to an increased indium content (that is, pre-configuration for longer wavelength). By carefully designing the spacings between holes 4, and thus the pyramids grown from the growth layer 2 through the holes 4, and tuning the growth conditions, InGaN pyramids 5 can be grown (and subsequently further truncated and processed to introduced QW layers) in one epitaxy run, where the indium composition (concentration) is tailored for the targeted emission wavelength, i.e., blue, green and red light based on the spacing between the mask openings. In this context, larger spacing provides InGaN growth suited for longer wavelength InGaN platelets (i.e., towards the red). It may be noted that a tailored lattice pattern for this purpose may be accomplished by design of the pattern of the mask holes 4 in the mask 3 over the growth layer 2. Grouped trigonal holes with larger c-c distance (Pixel Pitch between InGaN platelets of same colour) promotes higher indium incorporation and longer wavelength emission. Thus, a design with three different c-c- spacings will enable red, green, and blue platelet LEDs on same wafer.

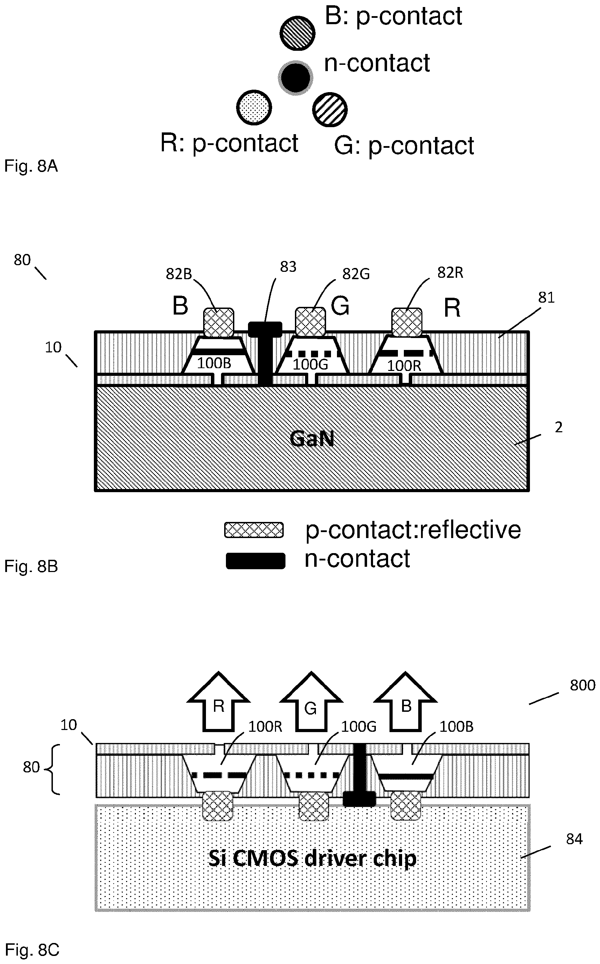

Figs 8A and 8B schematically illustrate contacting of the semiconductor structure 80 according to the proposed solution, whereas Fig. 8C shows a microLED device 800 where the semiconductor structure 80 is connected to a driver circuit. Where reference signs are not included in Fig. 8, it shall be noted that they refer to details highlighted in the other drawings.

Fig. 8A shows a top view of one example of a triangular arrangement of RGB MircoLEDs, where an n-contact is centrally configured in the triangular pixel arrangement. Separate n-contacts to the respective MicroLED is another option.

Fig. 8B schematically illustrates the semiconductor structure 80 according to an example of the proposed solution. As described and exemplified herein, the semiconductor structure 80 comprises an epiwafer 10, where a plurality of InGaN platelets 100 is grown through mask openings 4 of the epiwafer 10, each InGaN platelet comprising a QW layer 110 including one or more QWs. The InGaN platelets 100 have a truncated pyramid shape. Each InGaN platelet is configured for emission of one colour of RGB, and are denoted 100B, 100G, 100R. In this drawing, the buffer layer 2 still remains, but this layer may be stripped or thinned before or after contacting.

A contact spacer layer 81 may be applied over InGaN platelets 100B, 100G, 100R, wherein p-contacts 82B, 82G, 82R to the respective InGaN platelet project through the contact spacer layer 81 and bond to the respective top c-plane surface of the InGaN platelets 100B, 100G, 100R. The contact spacer layer 81 is a dielectric layer, which allows for the application of leads (not shown) to the p-contacts over the surface of the microLED device. An n-contact 83 for the group of pixels (or separate contacts) is formed to extend from a surface of the base side of the pyramids to the top c-plane side, for convenient connection of the driver circuit. The n-contact 83 may be a metal connection, according to the shown example.

Fig. 8C schematically illustrates a microLED device 800, comprising the semiconductor structure 80 according to the proposed solution. The drawing indicates attachment and connection of the semiconductor structure 80 to a driver circuit 84. Each InGaN platelet 100R, 100G, 100B has a top c-plane surface connectable to the driver circuit 84, by means of the respective connector 82R, 82G, 82B for generating light emission.

The driver circuits 84 are here exemplified by Si CMOS driver circuits. In some examples, thin film active transistor drivers may instead or additionally be used. While the top image of Fig. 8A suggests triangular grouping of RGB pixels with a central n-contact, the lower images show a linear representation for the sake of simplicity. Either is possible.

Where the micro-LED device 800 is configured to emit light through the base side of the InGaN platelets, the p-contacts 82B, 82G, 82R, connected to the upper c-planes of the respective InGaN platelets, may be reflective to increase light output.

The base substrate 1 (see Fig. 1) is removed. The original GaN growth layer 2 may, as mentioned, further be thinned or stripped. The epiwafer 10 of the microLED device 800 thus comprises the mask layer 3, and optionally a part of the growth layer 2.

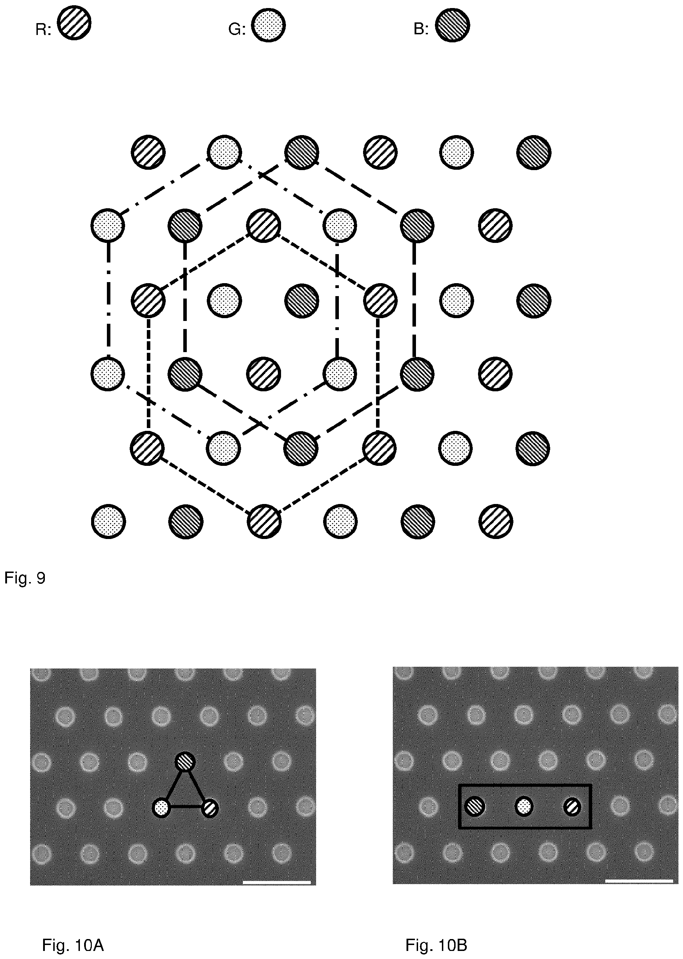

Fig. 9 shows an example of InGaN RGB platelet array design according to some examples of the proposed solution. Epitaxial growth and subsequent QW formation of InGaN platelets out of trigonally arranged holes in the growth mask, wherein each InGaN platelet has six neighbour InGaN platelets at a common distance, leads to very uniform growth conditions resulting in well-controlled compositions.

A hexagonal array is configured for each colour, as indicated in the drawing. The hexagonal pattern provides that the same distance/spacing is configured between all InGaN platelets prepared for the same emission wavelength. This is beneficial for growth uniformity. Specifically, by keeping trigonal symmetry (and centre-to-centre spacing) for red, green, and blue platelet LEDs, colour purity and uniformity across the wafer for each LED colour is very high.

Fig. 10A shows one example of a pixel group configuration, where a triplet of RGB InGaN platelets is combined in one pixel group, capable of realizing any colour in the visible spectrum. In this example, a triangular pixel group is configured.

Fig. 10B shows, by way of example, an alternative arrangement of a triplet of RGB InGaN platelets in one pixel group, capable of realizing any colour in the visible spectrum. In this example, a linear combination is configured.

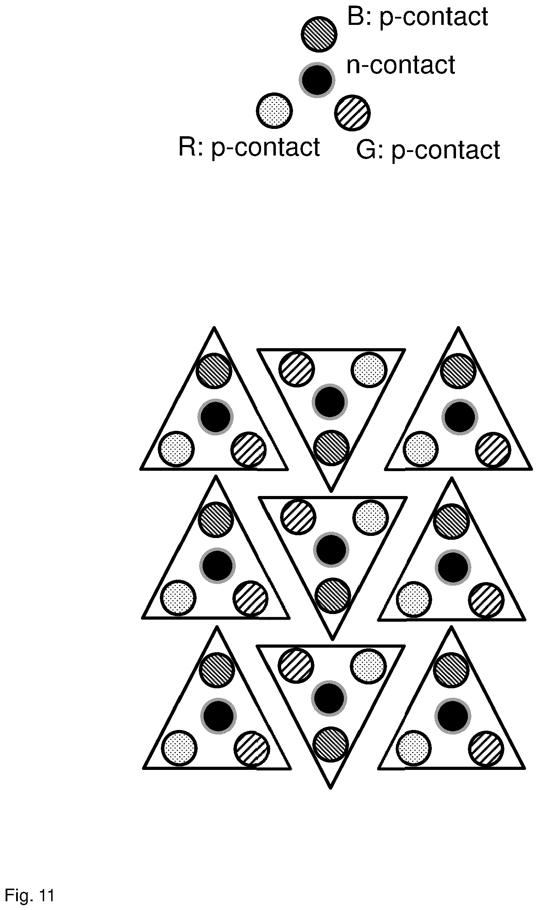

Fig. 11 shows an example of several pixel RGB groups, each comprising a triplet in accordance with the example of Fig. 10A. The pixel array layout demonstrates the arrangement of InGaN platelets 100 for red, green, and blue light emission in a display application.

The above-described embodiments provide examples of the proposed solution for a semiconductor structure for microLEDs and a method of fabricating the same. The disclosed technology minimizes defects in crystal formation and improves external quantum efficiency for microLEDs with sub-10 µm pixel size. It should be understood that the specific embodiments described herein are merely illustrative and not intended to limit the scope of the disclosure. Various modifications and adaptations may be made by those skilled in the art without departing from the scope of the disclosure as set forth in the appended claims.

With reference to the description above of the proposed solution and its examples and embodiments, various further related features and examples are outlined below.

The growth of InGaN pyramids through mask openings 4 of the epiwafer 10 enables the formation of InGaN platelets 100 with a specific shape and configuration. This controlled growth process contributes to the overall quality and performance of the resulting microLEDs, as it allows for the formation of InGaN platelets with minimal defects and optimized external quantum efficiency.

The growth mask 3, configured for growing InGaN pyramids, is preferably of a dielectric material such as Al₂O₃, SiNₓ, TiN. Holes 4 opened through the dielectric growth mask are preferably placed in a trigonal lattice arrangement, as shown in Figs 9-11, with hole dimensions in the 20-200 nm range and spaced 0.5 - 10 µm apart.

The grown InGaN pyramids 5 are preferably grown as n-type InGaN. The n-type InGaN pyramids may be doped with e.g., Si to a level of 1-5 × 10¹⁸ cm⁻³.

According to some examples, InGaN pyramids 5 of identical composition are concurrently grown, as n-type InGaN pyramids of certain indium concentration, wherein the pyramids are later processed to obtain separate RGB InGaN platelets.

According to other examples, for the blue LEDs, either GaN or InGaN pyramids with an indium content below 5% (wavelength <380 nm) may be used. For green LEDs, InGaN pyramids with an indium content around 10% (wavelength 420-430 nm) is preferred, and for red LEDs, 18%-20% indium contents (wavelength 480-500 nm) are preferred. Different content/concentration of indium may be obtained by growing the InGaN pyramids in separate processes.

In some examples, e.g., as described with reference to Fig. 6, the n-type InGaN may comprise more than one segment, separated in elevation over the epiwafer/mask layer. In some examples, a base layer of InGaN, closest to the epiwafer 10, may have the same indium composition as the original InGaN pyramids. However, for the cases shown Fig. 6, the fabrication method may start from InGaN pyramids with about 10% indium content, emitting 420-430nm light. After truncation of the pyramids, the templates can be used for blue and green microLEDs directly. For the red microLEDs, a buffer InGaN layer (below active region of QW layers) with indium content of e.g., about 18-20% (480-500 nm light) may be grown, followed by red InGaN QWs, to reduce risk of introducing stacking mismatch boundaries. The variation in indium concentration between the base layer and the buffer layer helps in achieving the desired emission wavelength for red light and improving the crystal quality of the InGaN platelets.

After the epitaxial growth of InGaN pyramids, the fabrication method may involve truncating the InGaN pyramids 5 to form truncated InGaN pyramids (and possibly further InGaN buffer growth). This process helps to create InGaN platelets 100 with a truncated pyramid shape, which is advantageous for the formation of QW layers at defined c-planes which are parallel to the epiwafer, and the overall performance of the microLEDs.

Upon truncating the pyramids 5, before QW layer growth (and buffer layer growth, where applicable) a protective layer may be applied, as illustrated in Figs 4 and 5, before LED epi. The protective layer should preferably be ALD deposited using a dielectric material similar to the growth mask (Al₂O₃ etc) since it can be deposited in a conformal manner, covering all facets in the same thickness. Other deposition methods usually lead to different deposition on different facets.

The InGaN platelets 100 comprise a QW layer formed within the platelets, also referred to as active layer, which as such may comprise one or more QWs. The QW may be about 2-3 nm thick. The compositions (i.e., the Indium concentration) for blue, green and red are about 10-15%, 25-27% and 35-40%, respectively. For the blue and green LEDs, an electron blocking layer (EBL) of AlGaN with an Al content of 10-25% and a thickness of 10-25 nm may be used. For the red LED, GaN or AlGaN with Al contents below 10% may be used as an EBL.

According to some examples, the QW layer is configured at a height in the InGaN platelets 100 correlating with emission wavelength, as explained and exemplified with reference to Fig. 4. This configuration allows for the formation of QW layers on InGaN platelets 100 for different emission wavelengths in a common epitaxy process, or so-called single shot epitaxy, for at least some layers of the QW layer, which simplifies the fabrication process and reduces manufacturing costs.

In some examples, the fabrication method may also comprise selective masking of the InGaN platelets 100 for epitaxial growth of QW layers for emission in a wavelength region of one of red, green, and blue. This selective masking process enables separate and dedicated creation of semiconductor structures with InGaN platelets configured for different emission wavelengths, allowing for the formation of microLEDs capable of emitting red, green, and blue light.

In some examples, the selective masking process may be performed using various techniques, such as photolithography, electron beam lithography, or nanoimprint lithography, to create the desired mask pattern on the epiwafer 10. The mask material may be selected based on its compatibility with the chosen masking technique and its ability to withstand the epitaxial growth process without degrading or causing unwanted contamination of the InGaN material. The use of selective masking for wavelength region emission in the fabrication method for the semiconductor structure for microLEDs offers several advantages. By enabling the formation of InGaN platelets 100 with different emission wavelengths on the same epiwafer 10, the selective masking process allows for the creation of microLEDs capable of emitting a full range of colours, which is for display applications. Additionally, the selective masking process can help to improve the efficiency with optimized growth conditions for each colour and uniformity of the epitaxial growth process, resulting in InGaN platelets 100 with fewer defects and higher external quantum efficiency. Furthermore, the use of a common epitaxy process in conjunction with the selective masking process can help to simplify the fabrication method and reduce the overall processing time and cost associated with producing the semiconductor structure for microLEDs.

In some examples, the InGaN platelets may comprise additional layers with varying indium concentrations to further optimize their performance. These additional layers may be located between the base layer and the buffer layer, or between the buffer layer and the QW layer. The additional layers may help in reducing strain, improving crystal quality, and tailoring the emission wavelength of the InGaN platelets.

A p-type InGaN top layer is further grown over the QW layer. For blue LED, the p-layer may be p-GaN, or p-InGaN with only a few percent (<10% or <5%) In, with a thickness of 100-200 nm. For the green and red LEDs p-InGaN with an indium content of 10% and 18%, respectively, may be used. The p-type doping is accomplished using e.g., Mg at a level at least above 1×10¹⁹ cm⁻³. Rapid thermal annealing may be used to activate the Mg doping.

The contact spacer layer 81, seen in Fig. 8B, can be a polymer. Preferably a dielectric spacer layer, such as PECVD SiOx, should be used together with CMP to expose the top c-plane of p-InGaN layer. Before the PECVD SiOx growth, a thin layer of ALD Al₂O₃ may be deposited first to protect the surface from being damaged by plasma at the beginning of SiOx deposition by PECVD and also to serve as surface passivation of the platelet surfaces.

Preferably, the n-type contacts to the base end of the InGaN platelets (typically to the growth layer, e.g., GaN buffer, on the opposite side of the mask layer) and the contacts to the p-type InGaN, may be processed on the platelet side of the epiwafer 10, as shown in Fig. 8B, which allows for convenient bonding to the driver circuits, such as CMOS driver chips. In this context, the flat c-plane top surface of the truncated InGaN platelets provides a suitable surface for bonding of the p-contacts.

In one example, the InGaN platelets 100 are arranged in groups on the epiwafer 10 for red, green, and blue light emission. This arrangement enables the fabrication of microLEDs with different emission wavelengths on a single epiwafer 10, which simplifies the manufacturing process and reduces costs.

In some examples, the InGaN platelets 100 are arranged in groups configured for different emission wavelengths. The emission wavelength of the InGaN platelets 100 increases with the spacing within the group. This arrangement allows for the tuning of the emission wavelength of the InGaN platelets 100 by adjusting the spacing within the group, providing flexibility in designing microLEDs with desired emission wavelengths already at InGaN pyramid growth.

In various examples, the InGaN platelets 100 are arranged in a trigonal pattern. In some examples, the InGaN platelets 100 configured for emission of the same colour are further arranged in a hexagonal pattern. These patterns provide an efficient arrangement of InGaN platelets 100 on the epiwafer 10 for red, green, and blue light emission, which contributes to the improvement of external quantum efficiency for microLEDs with sub-10 µm pixel.

Overall, the fabrication method for the semiconductor structure for microLEDs described herein provides a robust and efficient approach to creating high-quality microLEDs with minimized defects in crystal formation and improved external quantum efficiency. The various steps and optional features of the method contribute to the formation of InGaN platelets with precise control over their shape, configuration, and emission properties, ensuring optimal performance of the resulting microLEDs in a wide range of applications.

The use of selective masking for wavelength region emission in the fabrication method for the semiconductor structure for microLEDs offers several advantages. By enabling the formation of InGaN platelets 100 with different emission wavelengths on the same epiwafer 10, the selective masking process allows for the creation of microLEDs capable of emitting a full range of colours, which is for display applications. Additionally, the selective masking process can help to improve the efficiency and uniformity of the epitaxial growth process, resulting in InGaN platelets 100 with fewer defects and higher external quantum efficiency. Furthermore, the use of a common epitaxy process in conjunction with the selective masking process can help to simplify the fabrication method and reduce the overall processing time and cost associated with producing the semiconductor structure for microLEDs.

According to various aspects, the proposed solution may be configured in accordance with any of the items set out below.

Item 1. A semiconductor structure (80) for micro light-emitting diodes, microLEDs, comprising:
an epiwafer (10);
a plurality of InGaN platelets (100) monolithically grown on the epiwafer, each comprising a quantum well, QW, layer;
wherein the plurality of InGaN platelets comprises individual InGaN platelets configured for red, green, and blue light emission, respectively.

Item 2. The semiconductor structure according to claim 1, wherein the QW layer is configured at different height (h) over a surface of the epiwafer in the respective InGaN platelets (100), wherein said height correlates with emission wavelength.

Item 3. The semiconductor structure according to claim 1 or 2, wherein the QW layers are configured at increasing height in the InGaN platelets configured for different emission wavelength, in the order blue-green-red.

Item 4. The semiconductor structure according to any of claims 1-3, wherein each InGaN platelet comprises a base layer with a first indium concentration adjacent to the epiwafer, and a buffer layer with a second indium concentration between the base layer and the QW layer, wherein the second indium concentration is different between InGaN platelets configured for different colour emission.

Item 5. The semiconductor structure according to claim 4, wherein the base layer in each InGaN platelet has the same first indium concentration.

Item 6. The semiconductor structure according to claim 5, wherein the first indium concentration is 8-12%.

Item 7. The semiconductor structure according to any of claims 4-6, wherein the second indium concentration is lower than the first indium concentration in the InGaN platelets configured for blue emission.

Item 8. The semiconductor structure according to any of claims 4-7, wherein the second indium concentration is 5-10% in the InGaN platelets configured for blue emission.

Item 9. The semiconductor structure according to any of claims 4-8, wherein the second indium concentration is higher than the first indium concentration in the InGaN platelets configured for green and red emission, respectively.

Item 10. The semiconductor structure according to any of claims 4-9, wherein the second indium concentration is 10-15% in the InGaN platelets configured for green emission.

Item 11. The semiconductor structure according to any of claims 4-10, wherein the second indium concentration is 18-20% in the InGaN platelets configured for red emission.

Item 12. The semiconductor structure according to any preceding claim, wherein the InGaN platelets (100) have truncated pyramid shape with a top c-plane surface connectable to a driver circuit for generating light emission.

Item 13. The semiconductor structure according to any preceding claim, wherein the InGaN platelets (100) configured for the same emission wavelength are arranged in a hexagonal pattern on the epiwafer.

Item 14. The semiconductor structure according to any preceding claim, wherein the InGaN platelets are arranged in groups of adjacent InGaN platelets on the epiwafer.

Item 15. The semiconductor structure according to claim 14, wherein each group comprises a triplet of adjacent InGaN platelets (100) arranged in a trigonal pattern.

Item 16. The semiconductor structure according to claim 14 or 15, wherein each group comprises InGaN platelets (100) configured for blue, green and red emission.

Item 17. The semiconductor structure according to any of claims 1-15, wherein the InGaN platelets (100) are arranged in groups configured for the same emission wavelengths, and wherein spacing (PP) between the InGaN platelets within the respective group correlates with the emission wavelength for which the InGaN platelets are configured, such that the spacing increases in the order blue-green-red.

Item 18. A microLED device (800), comprising:
a semiconductor structure (80) according to any preceding claims; and
a driver circuit (84), connected by p-contacts to respective top portions of each InGaN platelet and by an n-contact to a base side of the epiwafer, for generating light emission from the respective InGaN platelet.

Item 19. A method of fabricating a semiconductor structure for microLEDs, comprising:
epitaxial growth of InGaN pyramids (5) through mask openings of an epiwafer (10);
truncating the InGaN pyramids to form truncated InGaN pyramids having c-plane top surfaces;
growing quantum well, QW, layers over the respective truncated InGaN pyramids; and
growing top InGaN layers over the respective QW layers to form individual InGaN platelets configured for red, green, and blue light emission, respectively.

Item 20. The method according to claim 19, wherein the QW layer is grown at different height (h) over a surface of the epiwafer in the respective InGaN platelets (100), wherein said height correlates with emission wavelength.

Item 21. The method according to claim 19 or 20, wherein the QW layer are grown at increasing height in the InGaN platelets configured for different emission wavelength, in the order blue-green-red.

Item 22. The method according to any of claims 19-21, wherein the truncated InGaN pyramids form respective base layers with a first indium concentration, the method further comprising:
growing a buffer layer with a second indium concentration on the base layer prior to growing the QW layer, wherein the second indium concentration is different between InGaN platelets configured for different colour emission.

Item 23. The method according to claim 22, wherein the base layer in each InGaN platelet has the same first indium concentration.

Item 24. The method according to any of claims 19 to 23, wherein the growing of quantum well layers on the InGaN platelets for different emission wavelengths is performed in a common epitaxy process.

## Claims

1. A semiconductor structure (80) for micro light-emitting diodes, microLEDs, comprising:
an epiwafer (10);
a plurality of InGaN platelets (100) monolithically grown on the epiwafer, each comprising a quantum well, QW, layer;
wherein the plurality of InGaN platelets comprises individual InGaN platelets configured for red, green, and blue light emission, respectively.

2. The semiconductor structure according to claim 1, wherein the QW layer is configured at different height (h) over a surface of the epiwafer in the respective InGaN platelets (100), wherein said height correlates with emission wavelength.

3. The semiconductor structure according to claim 1 or 2, wherein the QW layers are configured at increasing height in the InGaN platelets configured for different emission wavelength, in the order blue-green-red.

4. The semiconductor structure according to any of claims 1-3, wherein each InGaN platelet comprises a base layer with a first indium concentration adjacent to the epiwafer, and a buffer layer with a second indium concentration between the base layer and the QW layer, wherein the second indium concentration is different between InGaN platelets configured for different colour emission.

5. The semiconductor structure according to claim 4, wherein the second indium concentration is lower than the first indium concentration in the InGaN platelets configured for blue emission.

6. The semiconductor structure according to claim 4 or 5, wherein the second indium concentration is higher than the first indium concentration in the InGaN platelets configured for green and red emission, respectively.

7. The semiconductor structure according to any preceding claim, wherein the InGaN platelets (100) have truncated pyramid shape with a top c-plane surface connectable to a driver circuit for generating light emission.

8. The semiconductor structure according to any preceding claim, wherein the InGaN platelets are arranged in groups of adjacent InGaN platelets on the epiwafer wherein each group comprises InGaN platelets (100) configured for blue, green and red emission.

9. The semiconductor structure according to any of claims 1-7, wherein the InGaN platelets (100) are arranged in groups configured for the same emission wavelengths, and wherein spacing (PP) between the InGaN platelets within the respective group correlates with the emission wavelength for which the InGaN platelets are configured, such that the spacing increases in the order blue-green-red.

10. A microLED device (800), comprising:
a semiconductor structure (80) according to any preceding claims; and
a driver circuit (84), connected by p-contacts to respective top portions of each InGaN platelet and by an n-contact to a base side of the epiwafer, for generating light emission from the respective InGaN platelet.

11. A method of fabricating a semiconductor structure for microLEDs, comprising:
epitaxial growth of InGaN pyramids (5) through mask openings of an epiwafer (10);
truncating the InGaN pyramids to form truncated InGaN pyramids having c-plane top surfaces;
growing quantum well, QW, layers over the respective truncated InGaN pyramids; and
growing top InGaN layers over the respective QW layers to form individual InGaN platelets configured for red, green, and blue light emission, respectively.

12. The method according to claim 11, wherein the QW layer is grown at different height (h) over a surface of the epiwafer in the respective InGaN platelets (100), wherein said height correlates with emission wavelength.

13. The method according to claim 11 or 12, wherein the QW layer are grown at increasing height in the InGaN platelets configured for different emission wavelength, in the order blue-green-red.

14. The method according to any of claims 11-13, wherein the truncated InGaN pyramids form respective base layers with a first indium concentration, the method further comprising:
growing a buffer layer with a second indium concentration on the base layer prior to growing the QW layer, wherein the second indium concentration is different between InGaN platelets configured for different colour emission.

15. The method according to any of claims 11 to 14, wherein the growing of quantum well layers on the InGaN platelets for different emission wavelengths is performed in a common epitaxy process.

## Amended claims

### Amended claims in accordance with Rule 137(2) EPC.

1. A semiconductor structure (80) for micro light-emitting diodes, microLEDs, comprising:
an epiwafer (10);
a plurality of InGaN platelets (100B, 100G, 100R) monolithically grown on the epiwafer, each comprising a quantum well, QW, layer (111, 112, 113);
wherein the plurality of InGaN platelets comprises individual InGaN platelets configured for red, green, and blue light emission, respectively,
**characterized in that** the QW layer is configured at different height (h_{B}, h_{G}, h_{R}) over a surface of the epiwafer in the respective InGaN platelets (100), wherein said height correlates with emission wavelength.

2. The semiconductor structure according to claim 1, wherein the QW layers are configured at increasing height in the InGaN platelets configured for different emission wavelength, in the order blue-green-red.

3. The semiconductor structure according to claim 1 or 2, wherein each InGaN platelet comprises a base layer (61) with a first indium concentration adjacent to the epiwafer, and a buffer layer (62B, 62G, 62R) with a second indium concentration between the base layer and the QW layer, wherein the second indium concentration is different between InGaN platelets configured for different colour emission.

4. The semiconductor structure according to claim 3, wherein the base layer in each InGaN platelet has the same first indium concentration.

5. The semiconductor structure according to claim 3 or 4, wherein the second indium concentration is lower than the first indium concentration in the InGaN platelets configured for blue emission.

6. The semiconductor structure according to any of claims 3-5, wherein the second indium concentration is higher than the first indium concentration in the InGaN platelets configured for green and red emission, respectively.

7. The semiconductor structure according to any preceding claim, wherein the InGaN platelets (100) have truncated pyramid shape with a top c-plane surface connectable to a driver circuit for generating light emission.

8. The semiconductor structure according to any preceding claim, wherein the InGaN platelets are arranged in groups of adjacent InGaN platelets on the epiwafer wherein each group comprises InGaN platelets (100) configured for blue, green and red emission.

9. The semiconductor structure according to any of claims 1-7, wherein the InGaN platelets (100) are arranged in groups configured for the same emission wavelengths, and wherein spacing (PP) between the InGaN platelets within the respective group correlates with the emission wavelength for which the InGaN platelets are configured, such that the spacing increases in the order blue-green-red.

10. A microLED device (800), comprising:
a semiconductor structure (80) according to any preceding claims; and
a driver circuit (84), connected by p-contacts (82B, 82G, 82R) to respective top portions of each InGaN platelet and by an n-contact (83) to a base side of the epiwafer, for generating light emission from the respective InGaN platelet.

11. A method of fabricating a semiconductor structure for microLEDs, comprising:
epitaxial growth of InGaN pyramids (5) through mask openings of an epiwafer (10);
truncating the InGaN pyramids to form truncated InGaN pyramids (40B, 40G, 40R) having c-plane top surfaces;
growing quantum well, QW, layers (111, 112, 113) over the respective truncated InGaN pyramids; and
growing top InGaN layers over the respective QW layers to form individual InGaN platelets (100B, 100G, 100R) configured for red, green, and blue light emission, respectively, **characterized in that** the QW layer is grown at different height (h_{B}, h_{G}, h_{R}) over a surface of the epiwafer in the respective InGaN platelets (100), wherein said height correlates with emission wavelength.

12. The method according to claim 11, wherein the QW layer are grown at increasing height in the InGaN platelets configured for different emission wavelength, in the order blue-green-red.

13. The method according to claim 11 or 12, wherein the truncated InGaN pyramids form respective base layers with a first indium concentration, the method further comprising:
growing a buffer layer (62B, 62G, 62R) with a second indium concentration on the base layer prior to growing the QW layer, wherein the second indium concentration is different between InGaN platelets configured for different colour emission.

14. The method according to claim 13, wherein the base layer in each InGaN platelet has the same first indium concentration.

15. The method according to any of claims 11 to 14, wherein the growing of quantum well layers on the InGaN platelets for different emission wavelengths is performed in a common epitaxy process.
